# EUROPÄISCHE PATENTSCHRIFT

(11) **EP 1 314 209 B1**
(45) Veröffentlichungstag und Bekanntmachung des Hinweises auf die Patenterteilung: **03.10.2012**
(21) Anmeldenummer: 01967062.9
(22) Anmeldetag: 31.08.2001
(51) Int. Cl.: H01L 33/00, H01S 5/323

(54) **VERFAHREN ZUM HERSTELLEN EINES STRAHLUNGSEMITTIERENDEN HALBLEITERCHIPS AUF III-V-NITRIDHALBLEITER-BASIS UND STRAHLUNGSEMITTIERENDER HALBLEITERCHIP**
METHOD FOR PRODUCING A RADIATION-EMITTING SEMICONDUCTOR CHIP BASED ON III-V NITRIDE SEMICONDUCTOR MATERIAL, AND A CORRESPONDING RADIATION-EMITTING SEMICONDUCTOR CHIP
PROCEDE POUR PRODUIRE UNE PUCE A SEMI-CONDUCTEUR PHOTOEMETTRICE A BASE DE SEMI-CONDUCTEUR NITRURE III-V ET PUCE A SEMI-CONDUCTEUR PHOTOEMETTRICE CORRESPONDANTE

(30) Priorität: 31.08.2000 DE 10042947
(43) Veröffentlichungstag der Anmeldung: 28.05.2003
(73) Patentinhaber: OSRAM Opto Semiconductors GmbH, 93055 Regensburg (DE)
(72) Erfinder: BADER, Stefan, 93053 Regensburg (DE); FEHRER, Michael, 93077 Bad Abbach (DE); HAHN, Berthold, 93155 Hemau (DE); HÄRLE, Volker, 93164 Waldetzenberg (DE); LUGAUER, Hans-Jürgen, 93173 Wenzenbach (DE)
(74) Vertreter: Epping - Hermann - Fischer
(86) Internationale Anmeldenummer: PCT/DE2001/003348
(87) Internationale Veröffentlichungsnummer: WO 2002/019439

(56) Entgegenhaltungen:
- US-A- 5 739 554
- US-A- 5 798 537
- US-A- 5 851 905
- US-A- 5 985 687
- US-A- 6 046 464
- PATENT ABSTRACTS OF JAPAN vol. 1999, no. 10, 31. August 1999 (1999-08-31) & JP 11 145516 A (TOYODA GOSEI CO LTD), 28. Mai 1999 (1999-05-28) & US 6 121 121 A 19. September 2000 (2000-09-19)

## Beschreibung

Die Erfindung bezieht sich auf ein Verfahren zum Herstellen eines strahlungsemittierenden Halbleiterchips auf Basis von III-V-Nitridhalbleitermaterial nach dem Oberbegriff des Patentanspruchs 1 sowie auf einen strahlungsemittierenden Halbleiterchip nach dem Oberbegriff des Patentanspruchs 19.

Strahlungsemittierende Halbleiterbauelemente auf GaN-Basis sind beispielsweise aus US 5,874,747 bekannt. Solche Halbleiterbauelemente enthalten einen Halbleiterkörper mit einer Mehrzahl von Schichten, die aus GaN oder einem darauf basierenden Material bestehen. Gemäß der genannten Druckschrift ist die Mehrzahl von GaN basierenden Schichten auf ein SiC-Substrat aufgebracht.

Unter III-V-Nitridhalbleitermaterialien fallen im vorliegenden Zusammenhang die von GaN abgeleiteten oder mit GaN verwandten Materialien sowie darauf aufbauende, beispielsweise ternäre oder quaternäre Mischkristalle. Insbesondere fallen hierunter die Materialien AlN, InN, AlGaN (Al₁₋ₓGaₓN, 0≤x≤1), InGaN (In₁₋ₓGaₓN, 0≤x≤1), InAlN (In₁₋ₓAlₓN, 0≤x≤1) und AlInGaN (Al_{1-x-y}InₓGa_{y}N, 0≤x≤1, 0≤y≤1).

Im folgenden bezieht sich die Bezeichnung "III-V-Nitridhalbleitermaterial" auf die oben beschriebene Gruppe von Materialien. Weiterhin umfaßt diese Bezeichnung Materialien, die zur Ausbildung von Pufferschichten bei der epitaktischen Herstellung von Schichten der angeführten Materialsysteme verwendet werden.

Aus US 5,679,152 ist ferner bekannt, GaN-basierende Halbleiterkörper epitaktisch auf einem geeigneten Substrat, beispielsweise einem Si-Substrat, herzustellen, wobei nach der epitaktischen Abscheidung der GaN-Schichten das Substrat in situ entfernt wird.

Weiterhin ist aus US 5,985,687 ein Verfahren bekannt, bei dem auf einem Saphir-Substrat eine ZnO-Opferschicht aufgebracht wird und die Opferschicht durch nasschemisches Ätzen entfernt wird.

Aus US 5,786,606 sind GaN-basierende Halbleiterkörper bekannt, die ein intermediäres SiC-Substrat aufweisen, das auf dem ursprünglichen Epitaxiesubstrat gebildet ist. Der ursprüngliche Substratkörper wird bei der Herstellung entfernt.

Die Verwendung von Halbleiterkörpern, die ein SiC-Substrat enthalten, bedeutet für die Herstellung von Halbleiterbauelementen einen zusätzlichen, nicht unerheblichen Kostenaufwand, da SiC-Substrate selbst extrem kostenaufwendig sind. Werden mit jedem auf III-V-Nitridhalbleitermaterialien basierenden Halbleiterkörper Teile des SiC-Substrats in ein Halbleiterbauelement eingebaut, so sind die Kosten für das Halbleiterbauelement direkt an die Kosten des SiC-Substrats gebunden. Eine kostengünstige Herstellung des Halbleiterbauelements wird dadurch erschwert.

Weiterhin kann ein SiC-Substrat in auf III-V-Nitridhalbleiter basierenden Halbleiterchips zur Verringerung der Strahlungsausbeute führen, da SiC die von diesen emittierte Strahlung teilweise absorbiert und somit den Anteil auskoppelbarer Strahlung reduziert.

Bei dem in US 5,679,152 beschriebenen Herstellungsverfahren unter Verwendung von Si-Substraten können nur sehr dünne Substrate benutzt werden, die unmittelbar nach der Epitaxie entfernt werden müssen. Typischerweise liegt die zulässige Dicke solcher Substrate unter 1 µm.

Diese dünnen Substrate sind erforderlich, um Rißbildung im Halbleiterkörper aufgrund der verschiedenen thermischen Ausdehnungskoeffizienten zwischen Silizium und auf III-V-Nitridhalbleiter basierenden Materialien zu vermeiden.

Es ist Aufgabe der vorliegenden Erfindung, einen strahlungsemittierenden Halbleiterchip auf Basis von III-V-Nitridhalbleitermaterialien technisch einfach und daher kostengünstig herzustellen, wobei der Halbleiterchip eine hohe externe Quanteneffizienz aufweist.

Diese Aufgabe wird durch ein Verfahren nach Anspruch 1 gelöst. Vorteilhafte Weiterbildungen der Erfindung sind Gegenstand der Unteransprüche.

Erfindungsgemäß ist vorgesehen, den strahlungsemittierenden Halbleiterchip auf III-V-Nitridhalbleitermaterial-Basis als Dünnschichtelement auszubilden.

Unter einem Dünnschichtelement wird dabei eine Halbleiterschichtfolge verstanden, die im wesentlichen ausschließlich aus einem Stapel Epitaxieschichten auf der Basis von III-V-Nitridhalbleitermaterial besteht.

Das Dünnschichtelement besteht aus einer Mehrzahl von III-V-Nitridhalbleiter-Epitaxieschichten, wobei der Halbleiterkörper auf einer Seite durch eine n-leitende und auf der dieser gegenüberliegenden Seite durch eine p-leitende Epitaxieschicht begrenzt ist.

Das Dünnschichtelement ist mit der p-leitenden Seite auf einem leitfähigen Träger aufgebracht, der eine Montagefläche für das Dünnschichtelement aufweist und vorzugweise zugleich zur Kontaktierung des Dünnschichtelements verwendet werden kann.

Auf der n-leitenden Seite des Dünnschichtelements ist eine korrespondierende Kontaktfläche gebildet. Im folgenden bezieht sich die Bezeichnung "Kontaktfläche" ohne weitere Angaben auf diese Kontaktfläche.

Mit großem Vorteil weist der so gebildete Halbleiterchip kein Epitaxiesubstrat üblicher Dicke (>100µm) wie zum Beispiel ein SiC-Substrat auf, so daß die Materialkosten für das Halbleiterbauelement gesenkt sind.

Ein weiterer Vorteil der Dünnschichtausführung liegt darin, daß der Halbleiterkörper nur mehr kleine Reste eines strahlungsabsorbierenden Substrats oder gar kein strahlungsabsorbierendes Substrat enthält.

Daher kann die Strahlungsausbeute durch Verwendung eines reflektierenden Trägers gesteigert werden.

Eine vorteilhafte Weiterbildung der Erfindung besteht darin, bei dem Dünnschichtelement die auf der n-leitenden Seite begrenzende Epitaxieschicht als leitfähige Pufferschicht auszubilden.

Die Ausbildung von Pufferschichten bei der Herstellung von GaN-basierenden Halbleiterkörpern ist üblich, um eine Gitterfehlanpassung zwischen Epitaxiesubstrat und den auf die Pufferschicht folgenden Epitaxieschichten auszugleichen.

Eine leitfähige Pufferschicht bringt den großen Vorteil mit sich, daß mit dem so gebildeten Halbleiterkörper ein vertikal leitfähiges Halbleiterbauelement geschaffen werden kann.

Gegenüber isolierenden Pufferschichten ist dies vorteilhaft, da vertikal leitende Halbleiterchips mit geringerem Aufwand kontaktiert werden können. Ferner ist so eine größere laterale Ausdehnung der aktiven Schichten möglich.

Bei einer besonders bevorzugten Ausgestaltung der Erfindung ist die Pufferschicht mehrlagig gebildet. Durch eine Abfolge mehrerer Schichten unterschiedlicher Zusammensetzung ist es mit Vorteil möglich, sowohl die Leitfähigkeit der Pufferschicht als auch die Anpassung an die folgenden GaN-basierenden Schichten zu optimieren.

Bei einer bevorzugten Ausgestaltung der Erfindung besteht die Pufferschicht aus AlGaN-basierenden Materialien, wie beispielsweise Al₁₋ₓGaₓN mit 0≤x<1und Al_{1-x-y}InₓGa_{y}N mit 0≤x<1, 0≤y<1 und x+y<1.

Von besonderem Vorteil ist es hierbei, die der Kontaktfläche zugewandte Seite der Pufferschicht mit niedrigem Al-Gehalt auszubilden, um so eine gut leitfähige Pufferschicht zu erhalten.

Da die Oberflächengüte und die kristalline Qualität solcher Schichten mit niedrigem Al-Gehalt gering ist, ist es weiterhin vorteilhaft, die der Kontaktfläche abgewandte Seite der Pufferschicht mit hohem Al-Gehalt auszubilden. Durch den hohen Al-Gehalt wird die Oberflächengüte der Pufferschicht erhöht und eine gute Anpassung an nachfolgende III-V-Nitridhalbleiter-basierende Schichten erreicht.

Eine Pufferschicht mit niedrigem Al-Gehalt auf der Seite der Kontaktfläche und hohem Al-Gehalt auf der gegenüberliegenden Seite bildet damit mit großem Vorteil eine leitfähige Pufferschicht mit zugleich hoher Oberflächengüte.

Erfindungsgemäß ist zur Herstellung eines strahlungsemittierenden Halbleiterelements auf Basis von III-V-Nitridhalbleitermaterial vorgesehen, die III-V-Nitridhalbleiter-basierenden Schichten auf ein Epitaxiesubstrat aufzubringen, dessen Substratkörper einen an III-V-Nitridhalbleitermaterialien angepaßten oder einen im Vergleich zu III-V-Nitridhalbleitermaterialien größeren thermischen Ausdehnungskoeffizienten besitzt und das auf der Epitaxieseite von einer dünnen Aufwachsschicht, die Si(111) enthält, begrenzt wird.

Mit Vorteil wird so die thermische Ausdehnung des Epitaxiesubstrats bei der Herstellung des III-V-Nitridhalbleiterkörpers durch den Substratkörper bestimmt, so daß sich das Substrat thermisch ähnlich wie die aufzubringenden Schichten verhält.

Eine Si(111)-Oberfläche weist eine hexagonale Struktur auf und ist damit gut als Epitaxieoberfläche für III-V-Nitridhalbleitermaterialien geeignet.

Weiterhin sind Si(111)-Oberflächen leicht zu bearbeiten und für die Epitaxie vorzubereiten. Die Verarbeitungstechniken von Si(111) sind aufgrund der überragenden Verwendung dieses Materials in der Halbleiterindustrie sehr gut bekannt und erprobt.

Daher ist es auch mit Vorteil möglich, Epitaxiesubstrate mit einem Durchmesser herzustellen, der deutlich größer ist als der Durchmesser handelsüblicher SiC-Substrate.

Auch die erreichbare Oberflächengüte von Si(111)-Oberflächen hebt sich weit von der Oberflächengüte von SiC-Substraten ab.

Als Substratkörper wird vorzugsweise polykristallines SiC (PolySiC), GaN oder polykristallines GaN (PolyGaN) aufgrund der guten thermischen Anpassung an GaN-basierende Schichten verwendet. Weiterhin kann der Substratkörper Saphir (α-Al₂O₃) enthalten, der einen größeren thermischen Ausdehnungskoeffizienten als III-V-Nitridhalbleitermaterialien aufweist.

Diese Substratkörper sind deutlich kostengünstiger als die nach dem Stand der Technik verwendeten Substrate, da der Halbleiterkörper auf der Oberfläche der Aufwachsschicht abgeschieden wird und so vorteilhafterweise die Anforderungen an die kristallinen Eigenschaften des Substratkörpers reduziert sind. Aufgrund der reduzierten Anforderungen können insbesondere kostengünstige polykristalline Materialien eingesetzt werden.

Der Substratkörper ist mit der Aufwachsschicht vorzugsweise durch eine Haftschicht verbunden, die aus Siliziumoxid oder Siliziumnitrid besteht.

Die Ausbildung einer Haftschicht zwischen Substratkörper und Aufwachsschicht ist auf einfache Weise möglich, wobei die genannten Materialien eine besonders stabile Verbindung gewährleisten.

Bei einer besonders bevorzugten Weiterbildung des erfindungsgemäßen Herstellungsverfahrens wird das Verfahren nach der Aufbringung der III-V-Nitridhalbleiter-basierenden Schichten fortgeführt, indem in einem nächsten Schritt auf die III-V-Nitridhalbleiter-basierenden Schichten ein Träger aufgebracht wird.

Danach wird das Epitaxiesubstrat von den III-V-Nitridhalbleiter-basierenden Schichten abgelöst.

Mit Vorteil ist somit eine Wiederverwendung oder Weiterverwendung des Epitaxiesubstrats beziehungsweise des Substratkörpers möglich.

Die Verwendung einer Si(111)-Aufwachsschicht als Epitaxieoberfläche ist bei Ablösung des Epitaxiesubstrats vorteilhaft, da sich der Halbleiterkörper leicht, beispielsweise durch Ätzen, von dem Substratkörper lösen läßt. Die Si(111)-Aufwachsschicht stellt dabei eine Opferschicht dar.

Besonders vorteilhaft ist bei diesem Herstellungsverfahren die Möglichkeit einer kostengünstigen Herstellung der Halbleiterkörper unter Verwendung eines monokristallinen SiC-Substratkörpers, da der kostenintensive SiC-Substratkörper wieder- oder weiterverwendet werden kann.

Bei einer bevorzugten Weiterbildung des erfindungsgemäßen Herstellungsverfahrens wird nach der Ablösung des Epitaxiesubstrats auf die Fläche des Halbleiterkörpers, von der das Epitaxiesubstrat abgelöst wurde, eine Kontaktfläche aufgebracht.

Eine vorteilhafte Ausgestaltung des erfindungsgemäßen Herstellungsverfahrens besteht darin, vor der Ablösung des Epitaxiesubstrats die Mehrzahl der III-V-Nitridhalbleiter-Schichten zu strukturieren.

Unter Strukturierung sind dabei Maßnahmen zu verstehen, die lateral die Epitaxieschichten in eine Vielzahl einzelner, auf dem Epitaxiesubstrat mit Abstand voneinander nebeneinander angeordneter Epitaxieschichtstapel unterteilen. Bei einer Ablösung der Epitaxischichtstapel durch Ätzen bewirkt die Strukturierung mit Vorteil eine Vergrö-βerung der dem Ätzangriff ausgesetzten Oberfläche.

Bei einer vorteilhaften Weiterbildung der Erfindung wird bei dem oben beschriebenen Herstellungsverfahren anstatt eines Trägers zunächst ein Zwischenträger auf die auf III-V-Nitridhalbleitermaterial basierenden Epitaxieschichten aufgebracht. Danach wird wiederum das Epitaxiesubstrat abgelöst und ein Träger auf die Seite der Epitaxieschichten aufgebracht, von der das Epitaxiesubstrat abgelöst wurde. Im nächsten Schritt wird der Zwischenträger abgelöst.

Mit dieser Weiterbildung wird mit Vorteil die Schichtabfolge der auf III-V-Nitridhalbleitermaterial basierenden Schichten bezüglich des Trägers gegenüber dem oben beschriebenen Herstellungsverfahren umgekehrt. Diese Umkehr ist vorteilhaft, um auch nachfolgende Verfahren, insbesondere bei der Vergehäusung, anwenden zu können, die diese umgekehrte Schichtabfolge erfordern.

Eine besonders bevorzugte Ausgestaltung des erfindungsgemäßen Herstellungsverfahrens besteht darin, als erste Schicht auf das Epitaxiesubstrat eine elektrisch leitfähige Pufferschicht aufzubringen.

Eine solche Pufferschicht ist von besonderem Vorteil, um für die folgenden Epitaxieschichten eine Oberfläche mit optimal angepaßter Gitterstruktur zu erzeugen, die zugleich von den nachfolgenden Schichtmaterialien gut benetzt wird und so ein gleichmäßiges Wachstum der nachfolgenden Schichten ermöglicht.

Aufgrund der elektrischen Leitfähigkeit der Pufferschicht ist die Ausbildung vertikal leitfähiger Halbleiterbauelemente mit den oben beschriebenen, positiven Eigenschaften möglich.

Bevorzugt wird die Pufferschicht aus einer Mehrzahl von Einzelschichten auf AlGaN-Basis gebildet.

Dies ist von Vorteil, da eine Pufferschicht mit hohem Al-Anteil eine gitterangepaßte und gut benetzbare Oberfläche für weitere auf III-V-Nitridhalbleitermaterial basierende Schichten ausbildet, aber eine geringe Leitfähigkeit aufweist, während eine Pufferschicht mit niedrigem Al-Gehalt elektrisch gut leitet, aber eine geringere kristalline Qualität und Oberflächengüte besitzt.

Durch Ausbildung einer Mehrzahl solcher Schichten in Kombination ist es möglich, eine hohe elektrische Leitfähigkeit mit hoher kristalliner Qualität zu vereinen.

Dazu ist es günstig, substratseitig eine Schicht mit höherem Al-Gehalt auszubilden und zu den Epitaxieschichten hin, das heißt auf der dem Epitaxiesubstrat abgewandten Seite der Pufferschicht, eine Schicht mit niedrigerem Al-Gehalt abzuscheiden.

Bei einer besonders vorteilhaften Weiterbildung des erfindungsgemäßen Herstellungsverfahrens wird die Pufferschicht in zwei Schritten gebildet.

Im ersten Schritt wird auf die Aufwachsschicht des Epitaxiesubstrats eine Mehrzahl von elektrisch leitfähigen Bereichen aufgebracht. Als Material für die leitfähigen Bereiche eignet sich insbesondere ein InGaN-basierendes Material, wie In₁₋ₓGaₓN mit 0≤x<1 und In_{1-x-y}AlₓGa_{y}N mit 0≤x<1, 0≤y<1 und x+y<1, oder GaN.

Aufgrund der Neigung von Si und Ga, Domänen auszubilden, wird dabei eine weitgehend homogene Anordnung der leitfähigen Bereiche erreicht.

In einem zweiten Schritt wird diese Mehrzahl elektrisch leitfähiger Bereiche mit einer planarisierenden Füllschicht abgedeckt, wobei die Zwischenräume zwischen den leitfähigen Bereichen gefüllt werden.

Als Material hierfür eignet sich besonders eine AlGaN-Verbindung mit hohem Al-Gehalt. Die so hergestellte Pufferschicht eignet sich sehr gut zur Abscheidung weiterer Schichten auf Basis von III-V-Nitridhalbleitermaterial und weist eine hohe Leitfähigkeit auf.

Weitere Merkmale, Vorteile und Zweckmäßigkeiten der Erfindung ergeben sich aus der nachfolgenden Beschreibung von drei Ausführungsbeispielen in Verbindung mit den Figuren 1 bis 3.

Es zeigen:
- Figur 1: eine schematische Schnittansicht eines Ausführungsbeispiels eines erfindungsgemäßen Bauelements,
- Figur 2: eine schematische Darstellung eines Ausführungsbeispiels eines erfindungsgemäßen Herstellungsverfahrens und
- Figur 3: eine schematische Darstellung eines erfindungsgemäßen Herstellungsverfahrens für eine leitfähige Pufferschicht.

In den verschiedenen Ausführungsbeispielen sind gleiche oder gleichwirkende Bestandteile jeweils mit den gleichen Bezugszeichen versehen.

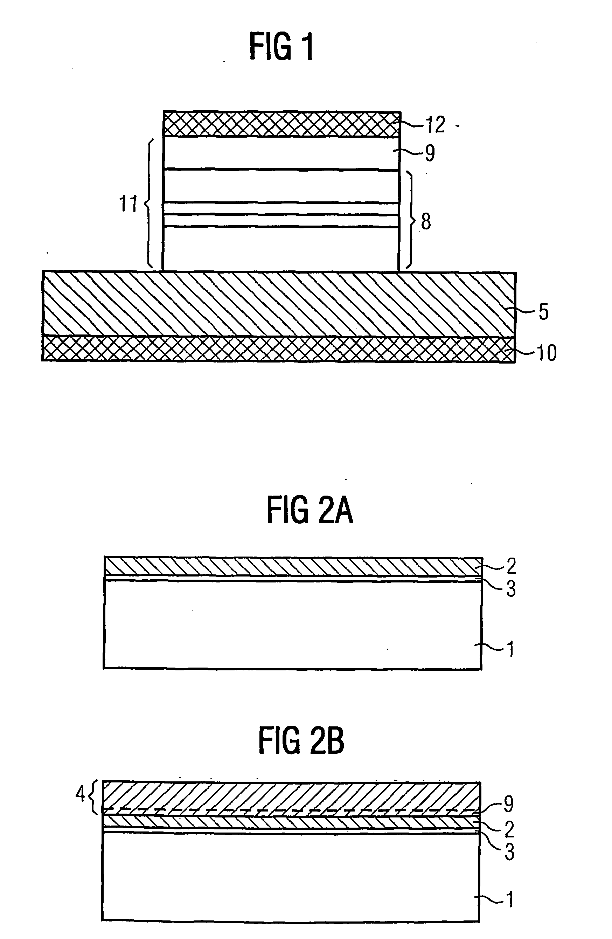

Der in Figur 1 dargestellte strahlungsemittierende Halbleiterchip weist einen Halbleiterkörper 11 in Form eines Dünnschichtelements auf, der aus einer leitfähigen Pufferschicht 9 und einer Schichtenfolge 8, die insbesondere Epitaxieschichten auf Basis von III-V-Verbindungshalbleitermaterial enthält, besteht. Auf die Pufferschicht 9 ist eine Kontaktfläche 12 aufgebracht, die, anders wie in Figur 1 dargestellt, auch nur einen Teil der Oberseite des Halbleiterkörpers 11 bedecken kann und beispielsweise Al aufweisen oder aus Al bestehen kann und als Bondpad ausgebildet ist.

Die Struktur der Schichtenfolge 8 bestimmt die Funktionalität des Halbleiterkörpers 11 beziehungsweise des damit gebildeten Chips. Diese Schichtenfolge 8 beinhaltet auch die der Strahlungserzeugung dienende aktive Schicht.

Der Halbleiterkörper 11 weist kein Epitaxiesubstrat auf.

Auf der Seite der Pufferschicht 9 ist der Halbleiterkörper 11 n-leitend und auf der dieser gegenüberliegenden Seite p-leitend ausgebildet.

Mit der p-leitenden Seite ist der Halbleiterkörper 11 auf einer Hauptfläche eines leitfähigen Trägers 5 aufgebracht.

Der Träger 5 weist auf der dem Halbleiterkörper 11 abgewandten Seite eine zweite Kontaktfläche 10 auf.

Mit Vorteil ist der so gebildete Halbleiterchip vertikal, das heißt senkrecht zu den Schichtebenen, durchgängig leitfähig. Dies ermöglicht einen lateral weitgehend homogenen Stromfluß durch das Bauelement und eine einfache Kontaktierung.

Ein weiterer Vorteil besteht darin, daß der Chip in lateraler Richtung problemlos skaliert werden kann. Unter lateraler Skalierung ist dabei der Übergang zu anderen lateralen Abmessungen des Chips zu verstehen. Dieser Übergang ist leicht möglich, da der Chip in lateraler Richtung nicht strukturiert ist, also keine Topologie aufweist.

Bei lateral strukturierten Bauelementen hingegen, beispielsweise mit zwei unterschiedlichen Kontaktflächen auf einer Hauptfläche, ist bei einer lateralen Skalierung eine Anpassung der lateralen Struktur zu berücksichtigen.

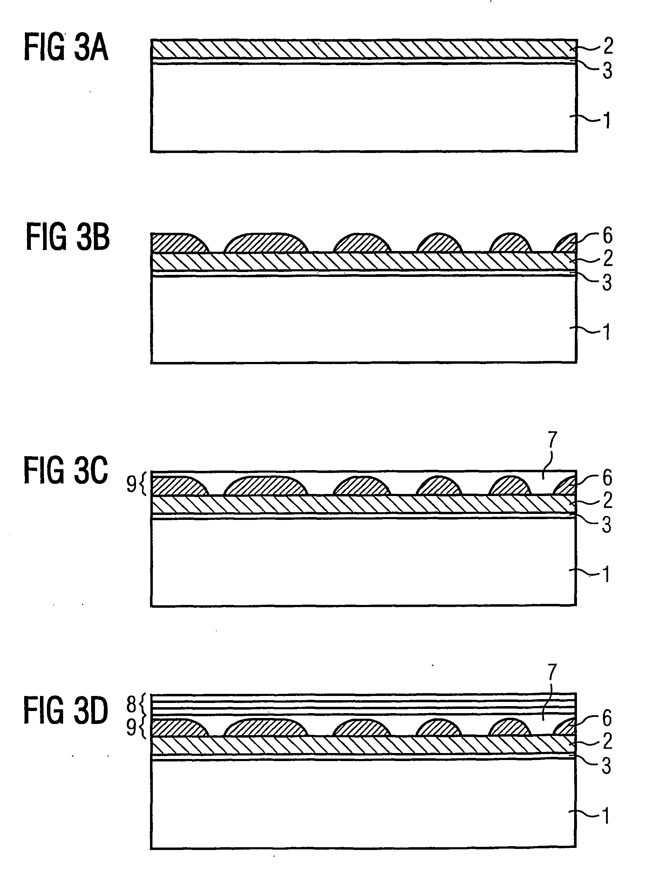

Voraussetzung für einen vertikal leitfähigen Chip ist eine leitfähige Pufferschicht 9. Diese Schicht ist zum Beispiel zweilagig aus III-V-Nitridhalbleitermaterialien gebildet. Die genauere Beschaffenheit der Pufferschicht 9 wird zusammen mit der Herstellung einer leitfähigen Pufferschicht anhand von Figur 3 erläutert.

Die erfindungsgemäß gebildeten Halbleiterkörper eignen sich aufgrund des direkten Bandübergangs sowie der Größe des Bandabstands von III-V-Nitridhalbleitermaterialien besonders zur Realisierung von Leuchtdiodenchips mit einer Zentralwellenlänge im gelben, grünen, grünblauen oder violetten Spektralbereich, Leuchtdioden mit besonders hoher Leuchtkraft und zur Realisierung von Halbleiterlasern mit einer Emissionswellenlänge im grünen bis violetten Spektralbereich.

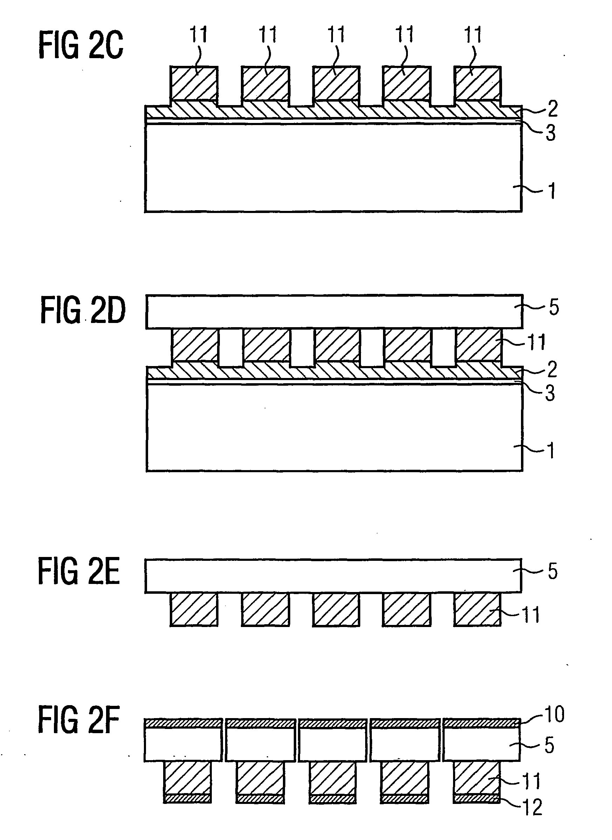

In Figur 2 ist in sechs Zwischenschritten a bis f schematisch ein Ausführungsbeispiel eines erfindungsgemäßen Herstellungsverfahrens dargestellt.

Ausgangspunkt bildet ein mehrlagiges Epitaxiesubstrat 100 (Figur 2a). Der Substratkörper 1 besteht aus SiC, bevorzugt Polysic.

Auf dem Substratkörper 1 ist eine Haftschicht 3, vorzugsweise bestehend aus Siliziumoxid gebildet, die den Substratkörper mit einer dünnen Aufwachsschicht 2 verbindet, die beispielsweise aus Si(111) besteht.

Die Dicke der Aufwachsschicht 2 ist dabei so gering gewählt, daß deren thermische Ausdehnung im wesentlichen von dem darunterliegenden Substratkörper 1 bestimmt wird. Typischerweise liegt die Dicke der Aufwachsschicht 2 zwischen etwa 0,1 µm und 20 µm, bevorzugt beträgt sie weniger als 10 µm und besonders bevorzugt liegt sie zwischen 0,1 µm und 2 µm.

Auf der Oberfläche der Aufwachsschicht 2 wird in einem nächsten Schritt eine Mehrzahl von Schichten 4 aus III-V-Nitridhalbleitermaterialien abgeschieden, Figur 2b.

Bevorzugt wird dabei als erstes eine leitfähige AlGaN-Pufferschicht 9 auf der Oberfläche der Aufwachsschicht 2 ausgebildet, da GaN selbst und InGaN-Verbindungen Si(111)- oder SiC-Oberflächen nur schlecht benetzen.

Die Pufferschicht 9 und die darauf abgeschiedenen angrenzenden Schichten auf Basis von III-V-Verbindungshalbleitermaterial sind n-leitend gebildet.

Auf der gegenüberliegenden, dem Epitaxiesubstrat 100 abgewandten Seite wird der Epitaxieschichtstapel von einer oder mehreren p-leitenden Schichten begrenzt.

Zwischen den n-leitenden und p-leitenden Schichten ist eine Mehrzahl Al_{1-x-y}GaₓIn_{y}N-basierender Schichten mit 0≤x≤1, 0≤x≤1 und x+y≤1 ausgebildet, die der Strahlungserzeugung im engeren Sinne dienen. Hierfür eignen sich alle dem Fachmann bekannten, strahlungserzeugenden Halbleiterstrukturen, insbesondere pn-Übergänge unter Ausbildung einer Einfach- oder Doppelheterostruktur sowie Einfach - und Mehrfachquantentopf-Strukturen.

Durch eine Mesaätzung werden im nächsten Schritt die Al_{1-x-y}GaₓIn_{y}N-basierenden Schichten lateral strukturiert, Figur 2c, so daß aus diesen eine Vielzahl separater, auf dem Epitaxiesubstrat 100 nebeneinander angeordneter Schichtstapel gebildet wird. Diese Schichtstapel stellen im Wesentlichen die noch nicht vereinzelten Dünnschichtelemente 11 der strahlungsemittierenden Chips dar.

Die Mesaätzung erfolgt bis in die Aufwachsschicht 2 des Epitaxiesubstrats 100 hinein, um in einem folgenden Schritt eine leichte Ablösung der Dünnschichtelemente 11 von dem Epitaxiesubstrat 100 zu ermöglichen.

Nach der Strukturierung der Al_{1-x-y}GaₓIn_{y}N-basierenden Schichten 4 wird auf der dem Epitaxiesubstrat 100 abgewandten, p-leitenden Seite der Dünnschichtelemente 11 ein Träger 5 oder alternativ ein Zwischenträger 13 aufgebracht. Als Trägermaterial kann beispielsweise GaAs oder Cu verwendet werden.

Im folgenden Schritt (Figur 2e) wird das Epitaxiesubstrat 100 von den Dünnschichtelement 11 abgelöst. Die Ablösung erfolgt naßchemisch durch Ätzen, wobei die Aufwachsschicht 2 zerstört wird. Die naßchemische Ablösung unter Abätzung der Aufwachsschicht 2 erfordert dabei einen wesentlich geringeren Aufwand als beispielsweise die Ablösung eines SiC-Substratkörpers.

Alternativ wird unter Verwendung eines Zwischenträgers 13 nach der Ablösung des Epitaxiesubstrats 100 an dessen Stelle ein Träger 5 aufgebracht und danach der Zwischenträger 13 abgelöst.

Die am Ende dieses Schritts gebildeten Strukturen sind bei beiden Alternativen sehr ähnlich und unterscheiden sich nur darin, daß bei Verwendung eines Zwischenträgers 13 die Pufferschicht 9 auf der dem Träger 5 zugewandten Seite des Halbleiterkörpers liegt (Figur 2e, rechts). Im anderen Fall ist die Pufferschicht 9 auf der dem Träger 5 abgewandten Seite des Halbleiterkörpers 11 ausgebildet.

Nachfolgend werden die Halbleiterkörper 11 sowie der Träger 5 mit Kontaktflächen 12 beziehungsweise 10 versehen. Nachfolgend wird der Träger 5 jeweils zwischen den Halbleiterkörpern 11 durchtrennt, so daß eine Mehrzahl der in Figur 1 dargestellten Halbleiterchips entsteht (Figur 2f).

Das Umbonden der Dünnschichtelemente 11 auf den Träger 5 beziehungsweise den Zwischenträger 13 in Verbindung mit der nachfolgenden Ablösung des Epitaxiesubstrats 100 ermöghicht mit Vorteil eine Weiterverwendung des Epitaxiesubstratkörpers 1, wodurch sich im Fall von SiC als Substratkörpermaterial eine erhebliche Kostenreduzierung ergibt.

Weiterhin entfallen so sämtliche im SiC-Substrat auftretenden Absorptionsverluste. Dies führt zu einer deutlich erhöhten Strahlungsausbeute.

Bei einem alternativen Herstellungsverfahren kann bei Verwendung kostengünstiger Substratkörper wie PolySiC oder PolyGaN auch das gesamte Substrat abgeätzt werden, wenn dessen Wiederverwendung keinen besonderen Vorteil darstellt.

In Figur 3 ist schematisch anhand von vier Zwischenschritten die Herstellung einer leitfähigen Pufferschicht 9 erläutert.

Als Epitaxiesubstrat 100 wird wie im oben beschriebenen Herstellungsverfahren ein SiC- oder PolySiC-Substratkörper 1 mit epitaxieseitiger Aufwachsschicht 2, die beispielsweise Si(111) enthält, verwendet (Figur 3a).

Auf der Aufwachsschicht 2 wird in einem ersten Schritt eine Nukleationschicht 6 in Form einer Mehrzahl von Quantenpunkten abgeschieden (Figur 3b).

Als Material hierfür wird AlGaInN mit niedrigem Al-anteil (<50%), InGaN oder GaN verwendet. Die Quantenpunkte sind hochleitfähig, bilden aber keine geschlossene Schicht. Somit entsteht auf der Oberfläche der Aufwachsschicht eine Mehrzahl von untereinander nicht zusammenhängenden, elektrisch leitfähigen Bereichen. Der Bedeckungsgrad kann je nach Materialzusammensetzung zwischen 1% und 99% variieren.

Auf der Quantenpunktschicht 6 wird eine planarisierende Füllschicht 7 auf AlGaN-Basis mit hohem Al-Gehalt, zum Beispiel AlₓGa₁₋ₓN mit x>0,5 abgeschieden (Figur 3c) so daß sich eine planare Struktur 9 ergibt.

Die leitfähigen Bereiche 6 bilden kanalartige Verbindungen durch die Pufferschicht 9 hindurch und gewährleisten eine gute elektrische Leitfähigkeit der Pufferschicht 9.

Auf der Pufferschicht 9 wird im nächsten Schritt eine Schichtenfolge 8, die insbesondere Epitaxieschichten auf Basis von III-V-Verbindungshalbleitermaterial enthält, abgeschieden (Figur 3c), die im Wesentlichen die Funktionalität des Halbleiterbauelements bestimmt.

Die weiteren Schritte zum Herstellen von Dünnschichtelementen und einzelnen Halbleiterchips entsprechen beispielsweise den im Zusammenhang mit den Figuren 2A bis 2C beschriebenen entsprechenden Schritten.

Die Erläuterung der Erfindung anhand der oben beschriebenen Ausführungsbeispiele stellt selbstverständlich keine Beschränkung der Erfindung auf diese dar.

Insbesondere kann die Zusammensetzungen der Halbleitermaterialen im jeweils angegebenen Rahmen den Erfordernissen und dem für das Bauelement vorgesehenen Einsatzbereich angepaßt werden.

Weiterhin kann durch die Zusammensetzung der Halbleitermaterialien innerhalb der aktiven Schicht des Halbleiterkörpers die Zentralwellenlänge der erzeugten Strahlung festgelegt werden.

## Patentansprüche

1. Verfahren zum Herstellen eines strahlungsemittierenden Halbleiterchips mit einem Dünnschichtelement (11) auf Basis von III-V-Nitridhalbleitermaterial, bei dem
- eine Schichtenfolge des Dünnschichtelements (11) auf einem Epitaxiesubstrat (100) abgeschieden wird,
- das Dünnschichtelement mit einem Träger (5) verbunden wird und
- das Epitaxiesubstrat (100) von dem Dünnschichtelement entfernt wird,
wobei
- das Epitaxiesubstrat (100) einen Substratkörper (1) aus SiC, GaN oder Saphir und eine Aufwachsschicht (2) aufweist, wobei der Substratkörper vermittels einer Haftschicht (3) mit der Aufwachsschicht (2) verbunden ist,
- die Aufwachsschicht (2) eine Si(111)-Schicht (2) aufweist, und
- auf der Aufwachsschicht (2) die Schichtenfolge des Dünnschichtelements (11) epitaktisch abgeschieden wird.

2. Verfahren nach Anspruch 1,
**dadurch gekennzeichnet, daß**
- das Epitaxiesubstrat (100) einen Substratkörper (1) aus PolySiC oder PolyGaN aufweist.

3. Verfahren nach Anspruch 1 oder 2,
**dadurch gekennzeichnet, daß** die Haftschicht (3) aus Siliziumoxid oder Siliziumnitrid besteht.

4. Verfahren nach einem der Ansprüche 1 bis 3,
**dadurch gekennzeichnet, daß** vor dem Aufbringen des Trägers (5) die Schichtenfolge des Dünnschichtelements (11) in eine Mehrzahl von einzelnen, voneinander getrennten Dünnschichtelementen (11) strukturiert wird.

5. Verfahren nach einem der Ansprüche 1 bis 4,
**dadurch gekennzeichnet, daß** nach dem Ablösen des Epitaxiesubstrats das Dünnschichtelement (11) kontaktiert wird.

6. Verfahren nach einem der Ansprüche 1 bis 5, **dadurch gekennzeichnet, daß** nach dem Aufbringen der Schichtenfolge das Verfahren fortgeführt wird mit den Schritten
- Aufbringen eines Zwischenträgers auf die Schichtenfolge;
- Ablösen des Epitaxiesubstrats;
- Aufbringen eines Trägers (5) auf die Seite der Schichtenfolge, von der das Epitaxiesubstrat abgelöst wurde; und
- Ablösen des Zwischenträgers.

7. Verfahren nach Anspruch 6,
**dadurch gekennzeichnet, daß** vor dem Aufbringen des Zwischenträgers die Mehrzahl von GaN-basierenden Schichten (4) strukturiert wird.

8. Verfahren nach Anspruch 6 oder 7,
**dadurch gekennzeichnet, daß** nach dem Ablösen des Zwischenträgers das Dünnschichtelement (11) kontaktiert wird.

9. Verfahren nach einem der Ansprüche 1 bis 8,
**dadurch gekennzeichnet, daß** als erste Schicht auf der Oberfläche der Aufwachsschicht (2) eine elektrisch leitfähige Pufferschicht (9) ausgebildet wird.

10. Verfahren nach Anspruch 9,
**dadurch gekennzeichnet, daß** die Pufferschicht (9) aus einer Mehrzahl von Einzelschichten auf AlGaN-Basis gebildet wird.

11. Verfahren nach Anspruch 10,
**dadurch gekennzeichnet, daß** die an die Aufwachsschicht (2) angrenzende Einzelschicht der Pufferschicht (9) einen höheren Al-Gehalt aufweist als eine dieser aus Sicht der Aufwachsschicht (2) nachgeordnete Einzelschicht.

12. Verfahren nach Anspruch 10 oder 11,
**dadurch gekennzeichnet, daß** die Einzelschicht auf der der Aufwachsschicht (2) abgewandten Seite der Pufferschicht (9) einen niedrigeren Al-Gehalt aufweist als eine dieser aus Sicht der Aufwachsschicht (2) vorgeordnete Einzelschicht.

13. Verfahren nach einem der Ansprüche 9 bis 12,
**dadurch gekennzeichnet, daß** die Pufferschicht gebildet wird durch die Schritte
- Aufbringen einer Mehrzahl von voneinander in Abstand befindlichen elektrisch leitfähigen Bereichen auf die Aufwachsschicht (2), und
- Aufbringen einer planarisierenden Füllschicht (7).

14. Verfahren nach Anspruch 13,
**dadurch gekennzeichnet, daß** die Mehrzahl elektrisch leitfähiger Bereiche durch Verwendung von InGaN-Material, GaN-Material oder InN-Material gebildet wird.

15. Verfahren nach Anspruch 13 oder 14,
**dadurch gekennzeichnet, daß** die Füllschicht (7) AlGaN oder AlGaInN mit einem derart hohen Al-Anteil aufweist, dass eine plane Schicht entsteht.

16. Verfahren nach einem der Ansprüche 1 bis 15,
**dadurch gekennzeichnet, daß** die Dicke der Aufwachsschicht zwischen etwa 1 µm und 20 µm liegt, insbesondere kleiner als 10 µm ist.

17. Verfahren nach einem der Ansprüche 1 bis 16,
**dadurch gekennzeichnet, daß** das Epitaxiesubstrat einen an das Material des Dünnschichtelements (11) angepaßten thermischen Ausdehnungskoeffizienten oder einen größeren thermischen Ausdehnungskoeffizienten als dieses Material besitzt.

## Claims

1. Method for fabricating a radiation-emitting semiconductor chip having a thin-film element (11) based on III-V nitride semiconductor material, in which method
- a layer sequence of the thin-film element (11) is deposited on an epitaxy substrate (100),
- the thin-film element is joined to a carrier (5), and
- the epitaxy substrate (100) is removed from the thin-film element,
wherein
- the epitaxy substrate (100) has a substrate body (1) made from SiC, GaN or sapphire and a growth layer (2), the substrate body being joined to the growth layer (2) by means of a bonding layer (3),
- the growth layer (2) includes an SiC (111) layer (2),
and
- the layer sequence of the thin-film element (11) is deposited on the growth layer (2) by epitaxy.

2. Method according to Claim 1,
**characterized in that**
- the epitaxy substrate (100) has a substrate body (1) made from PolySiC or PolyGaN.

3. Method according to Claim 1 or 2, **characterized in that** the bonding layer (3) consists of silicon oxide or silicon nitride.

4. Method according to one of Claims 1 to 3, **characterized in that** before the carrier (5) is applied, the layer sequence of the thin-film element (11) is patterned into a plurality of individual thin-film elements (11) which are separate from one another.

5. Method according to one of Claims 1 to 4, **characterized in that** after the epitaxy substrate has been removed, contact is made with the thin-film element (11).

6. Method according to one of Claims 1 to 5, **characterized in that** after the layer sequence has been applied, the method is continued by the steps of
- applying a temporary carrier to the layer sequence;
- removing the epitaxy substrate;
- applying a carrier (5) to that side of the layer sequence from which the epitaxy substrate has been removed; and
- removing the temporary carrier.

7. Method according to Claim 6, **characterized in that** the plurality of GaN-based layers (4) is patterned prior to the application of the temporary carrier.

8. Method according to Claim 6 or 7, **characterized in that** contact is made with the thin-film element (11) after the temporary carrier has been removed.

9. Method according to one of Claims 1 to 8, **characterized in that** the first layer formed on the surface of the growth layer (2) is an electrically conductive buffer layer (9).

10. Method according to Claim 9, **characterized in that** the buffer layer (9) is formed from a plurality of individual layers based on AlGaN.

11. Method according to Claim 10, **characterized in that** the individual layer of the buffer layer (9) which adjoins the growth layer (2) has a higher Al content than an individual layer which follows it, as seen from the growth layer (2).

12. Method according to Claim 10 or 11, **characterized in that** the individual layer on that side of the buffer layer (9) which is remote from the growth layer (2) has a lower Al content than an individual layer which precedes it, as seen from the growth layer (2).

13. Method according to one of Claims 9 to 12, **characterized in that** the buffer layer is formed by the steps of
- applying a plurality of electrically conductive regions, which are located at a distance from one another, to the growth layer (2), and
- applying a planarizing filler layer (7).

14. Method according to Claim 13, **characterized in that** the plurality of electrically conductive regions are formed by using InGaN material, GaN material or InN material.

15. Method according to Claim 13 or 14, **characterized in that** the filler layer (7) includes AlGaN or AlGaInN, with an Al content which is so high that a planar layer is formed.

16. Method according to one of Claims 1 to 15, **characterized in that** the thickness of the growth layer is between approximately 1 µm and 20 µm, in particular is less than 10 µm.

17. Method according to one of Claims 1 to 16, **characterized in that** the epitaxy substrate has a coefficient of thermal expansion which is matched to the material of the thin-film element (11) or a greater coefficient of thermal expansion than this material.

## Revendications

1. Procédé de fabrication d'une puce semi-conductrice émettant un rayonnement et dotée d'un élément (11) en couche mince basé sur un matériau semi-conducteur de nitrure de III-V, dans lequel
- des couches successives de l'élément (11) en couche mince sont déposées sur un substrat d'épitaxie (100),
- l'élément en couche mince est relié à un support (5) et
- le substrat d'épitaxie (100) est enlevé de l'élément en couche mince,
- le substrat d'épitaxie (100) présentant un corps de substrat (1) en SiC, GaN ou saphir et une couche de croissance (2), le corps de substrat étant relié à la couche de croissance (2) au moyen d'une couche d'adhérence (3),
- la couche de croissance (2) présentant une couche (2) de Si (111) et
- la succession des couches de l'élément (11) en couche mince est déposée par épitaxie sur la couche de croissance (2).

2. Procédé selon la revendication 1, **caractérisé en ce que** le substrat d'épitaxie (100) présente un corps de substrat (1) en polySiC ou polyGaN.

3. Procédé selon les revendications 1 ou 2, **caractérisé en ce que** la couche d'adhérence (3) est constituée d'oxyde de silicium ou de nitrure de silicium.

4. Procédé selon l'une des revendications 1 à 3, **caractérisé en ce qu'**avant l'application du support (5), la succession des couches de l'élément (11) en couche mince est structurée en plusieurs éléments (11) en couche mince distincts et séparés les uns des autres.

5. Procédé selon l'une des revendications 1 à 4, **caractérisé en ce qu'**après l'enlèvement du substrat d'épitaxie, l'élément (11) en couche mince est mis en contact.

6. Procédé selon l'une des revendications 1 à 5, **caractérisé en ce qu'**après l'application de la succession de couches, le procédé se poursuit par les étapes qui consistent à _{:}
- appliquer un support intermédiaire sur la succession de couches,
- enlever le substrat d'épitaxie,
- appliquer un support (5) sur le côté de la succession de couches duquel le substrat d'épitaxie a été enlevé et
- enlever le support intermédiaire.

7. Procédé selon la revendication 6, **caractérisé en ce qu'**avant l'application du support intermédiaire, les différentes couches (4) à base de GaN sont structurées.

8. Procédé selon les revendications 6 ou 7, **caractérisé en ce qu'**après l'enlèvement du support intermédiaire, l'élément (11) en couche mince est mis en contact.

9. Procédé selon l'une des revendications 1 à 8, **caractérisé en ce qu'**une couche tampon (9) électriquement conductrice est formée comme première couche à la surface de la couche de croissance (2).

10. Procédé selon la revendication 9, **caractérisé en ce que** la couche tampon (9) est formée de plusieurs couches distinctes à base d'AlGaN.

11. Procédé selon la revendication 10, **caractérisé en ce que** la couche individuelle de la couche tampon (9) adjacente à la couche de croissance (2) présente une teneur en Al plus élevée qu'une couche individuelle suivante plus éloignée de la couche de croissance (2).

12. Procédé selon les revendications 10 ou 11, **caractérisé en ce que** la couche individuelle située sur le côté de la couche tampon (9) non tournée vers la couche de croissance (2) présente une teneur en Al plus basse qu'une couche individuelle plus proche de la couche de croissance (2).

13. Procédé selon l'une des revendications 9 à 12, **caractérisé en ce que** la couche tampon est formée par les étapes qui consistent à _{:}
- appliquer plusieurs parties électriquement conductrices situées à distance les unes des autres sur la couche de croissance (2) et
- appliquer une couche de remplissage (7) qui assure le planage.

14. Procédé selon la revendication 13, **caractérisé en ce que** les différentes parties électriquement conductrices sont formées en utilisant un matériau à base d'InGaN, un matériau à base de GaN ou un matériau à base d'InN.

15. Procédé selon les revendications 13 ou 14, **caractérisé en ce que** la couche de remplissage (7) présente de l'AlGaN ou de l'AlGaInN dont la teneur en Al est suffisamment élevée pour former une couche plane.

16. Procédé selon l'une des revendications 1 à 15, **caractérisé en ce que** l'épaisseur de la couche de croissance est comprise entre environ 1 µm et 20 µm et en particulier est inférieure à 10 µm.

17. Procédé selon l'une des revendications 1 à 16, **caractérisé en ce que** le substrat d'épitaxie possède un coefficient de dilatation thermique adapté au matériau de l'élément (11) en couche mince ou un coefficient de dilatation thermique plus élevé que celui de ce matériau.
